(19) **Europäisches Patentamt European Patent Office Office européen des brevets**

(11) **EP 2 871 474 B1**

(12) **EUROPEAN PATENT SPECIFICATION**

(45) Date of publication and mention
of the grant of the patent:
**07.03.2018 Bulletin 2018/10**

(51) Int Cl.:
*G01N 29/02* (2006.01)  *G01N 29/12* (2006.01)
*G01N 29/24* (2006.01)  *H01L 41/113* (2006.01)
*H03H 9/25* (2006.01)

(21) Application number: **13192079.5**

(22) Date of filing: **08.11.2013**

(54) **SAW sensor based on Fabry-Pérot-type resonator**

SAW-Sensor auf Basis eines Fabry-Pérot-Resonators

Capteur SAW basé sur un résonateur de type Fabry-Pérot

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.05.2015 Bulletin 2015/20**

(73) Proprietor: **Pro-micron GmbH & Co. KG
87600 Kaufbeuren (DE)**

(72) Inventors:
• **Helbig, Christian
87674 Ruderatshofen (DE)**
• **Plessky, Viktor
CH-Gorgier 2025 (CH)**

(74) Representative: **Raffay & Fleck
Patentanwälte
Grosse Bleichen 8
20354 Hamburg (DE)**

(56) References cited:
**EP-A1- 1 336 892     SU-A1- 1 629 835
US-A- 5 283 037     US-A1- 2006 049 714
US-B1- 7 777 625**

• **SCHWELB O: "AXIAL MODES OF
ACOUSTICALLY COUPLED SURFACE
ACOUSTIC WAVE FABRY- PEROT
RESONATORS", JOURNAL OF APPLIED
PHYSICS, AMERICAN INSTITUTE OF PHYSICS, 2
HUNTINGTON QUADRANGLE, MELVILLE, NY
11747, vol. 68, no. 2, 15 July 1990 (1990-07-15),
pages 474-481, XP000436494, ISSN: 0021-8979,
DOI: 10.1063/1.347185**
• **GRATE AND FRYE: "Acoustic Wave Sensors",
SENSORS UPDATE, XX, XX, 1 January 1996
(1996-01-01), pages 37-83, XP002205093, DOI:
10.1002/1616-8984(199610)2:1<37::AID-SEUP3
7>3.0.CO;2-F**
• **ULRICH WOLFF ET AL: "SAW Sensors for Harsh
Environments", IEEE SENSORS JOURNAL, IEEE
SERVICE CENTER, NEW YORK, NY, US, vol. 1,
no. 1, 1 June 2001 (2001-06-01), XP011055570,
ISSN: 1530-437X**
• **TANSKI W J: "Surface Acoustic Wave
Resonators on Quartz", IEEE TRANSACTIONS
ON SONICS AND ULTRASONICS, IEEE, US, vol.
26, no. 2, 1 March 1979 (1979-03-01), pages
93-104, XP011404253, ISSN: 0018-9537, DOI:
10.1109/T-SU.1979.31073**

**Description**

FIELD OF THE INVENTION

The invention relates to Surface Acoustic Wave (SAW) sensors which may be used for example to detect temperature, deformation, etc., in particular based on SAW resonators, including sensors interrogated remotely.

BACKGROUND OF THE INVENTION

Passive SAW sensors demonstrate such merits as wireless distant interrogation, no battery operation (and no energy harvesting of any sort), low cost, operation at high temperatures, in harsh environments and even in ionizing radiation environment. They can be fixed on moving machine parts or rotating parts and need no maintenance. Such passive SAW sensors typically include resonator structures in order to amplify a sensor response at a chosen frequency, the resonance frequency of the resonator.

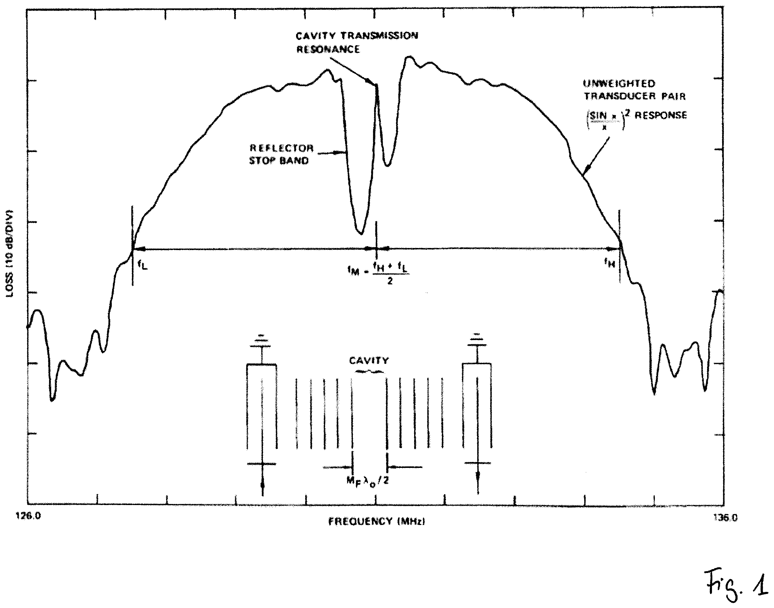

Typical SAW resonators of one currently known and widely used type comprise a single transducer, typically an interdigital transducer (IDT), arranged within a resonator cavity formed in a spacing between two reflector gratings. By means of said IDT resonating SAW are induced in the surface of a base structure which SAW are reflected by the reflector gratings and resonate within the resonator at resonance frequency. The same IDT may be used to transform the resonating SAW energy into an electric response signal. Such resonator, e.g., is disclosed by William J. Tanski in "Surface Acoustic Wave Resonators on Quartz", IEEE Transactions on Sonics and Ultrasonics, Vol. SU-26, No. 2, March 1979. It is shown there in Fig. 1 of the said article.

A SAW resonator of the same kind is also shown and described in KR 1020010056544 A. In this disclosure the authors name the resonator disclosed to be designed in a "Fabry-Perot form". This, however, is seen as a misleading naming of the structure and device as Fabry-Perot resonators - known form optical applications - are transmission devices with a radiation source on one side of the resonator and a specific pattern of transmission to be observed on the opposite side of said device.

As stated above, Fabry-Perot resonators are well known structures used in optical applications to - by means of resonance by interference effects - for example form optical filter elements or the like. They are construed of two reflectors arranged in parallel and with their reflector planes perpendicular to a direction of propagation of light and with a spacing or gap between them. These mirrors are almost ideal mirrors (i.e. with reflectivity closest most to 100%) and multiple reflection of the optical waves inside the cavity occur. This leads to an accumulation of energy inside the resonator resulting in the amplitude or intensity, i.e. the energy density, of the reflected waves inside the resonator being much higher than the energy density of the incident wave. The width of the gap, i.e. the spacing between or distance of the reflectors determines the frequency (frequencies) for which resonance occurs, for which optical energy will exit the Fabry-Perot resonator structure. For such device regarding the distance $\Delta f$ between resonance frequencies for which maximum resonance occurs the following formula applies:

$$\Delta f = \frac{c}{2nL},$$

with n being the refractive index, c the velocity of the light and L the width of the gap.

As stated before the physical effect which leads to such resonance is enhancement of the optical energy inside the resonator (inside the gap) by means of constructive interference at the specific resonance frequency/frequencies (of higher order) and destructive interference (extinction) for the intermediate frequency bands.

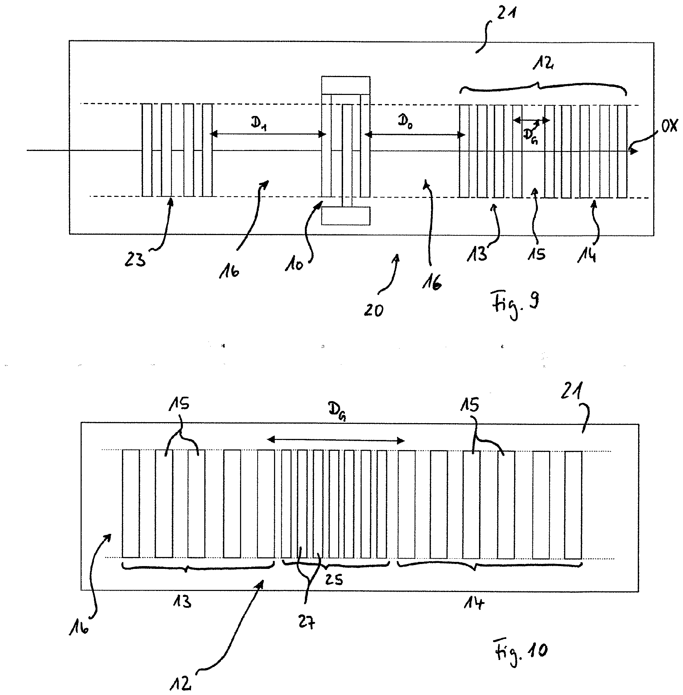

It has been described in the art that analogue structures can be used with similar effects (constructive interference for specific resonance frequencies and extinction for frequency bands aside the resonance frequencies) for SAWs. These elements basically follow similar or analogue physics and are named Fabry-Perot-type resonators (or similar) in the art. William J. Tanski in "Surface Acoustic Wave Resonators on Quartz" (see above) described such behavior of SAW resonators with respect to transmission through a Fabry-Perot-type resonator structure. The structure and its resonance behavior is shown in Fig. 10 of this disclosure, which figure is included in the figures of this application as Fig. 1.

However, the SAW resonator according to this structure has only rarely been used, because the reflector gratings (which may - in analogy to optics - be called "Bragg-type reflectors" have finite stopband, and outside this stopband the structure becomes transparent for SAW. The transmission characteristics of such a resonator, although including the transmission resonance, has other frequencies of high transmission on both sides of this peak, which cannot be acceptable for the application of such device both as a narrow-band filter, and as a stabilizing element for an oscillator. Another feature of the SAW Fabry-Perot resonator, presented in Fig. 1 is that it is a two-port-device, while for many applications, including SAW sensors, the one-port-resonators, similar to crystal bulk-wave resonators are preferred.

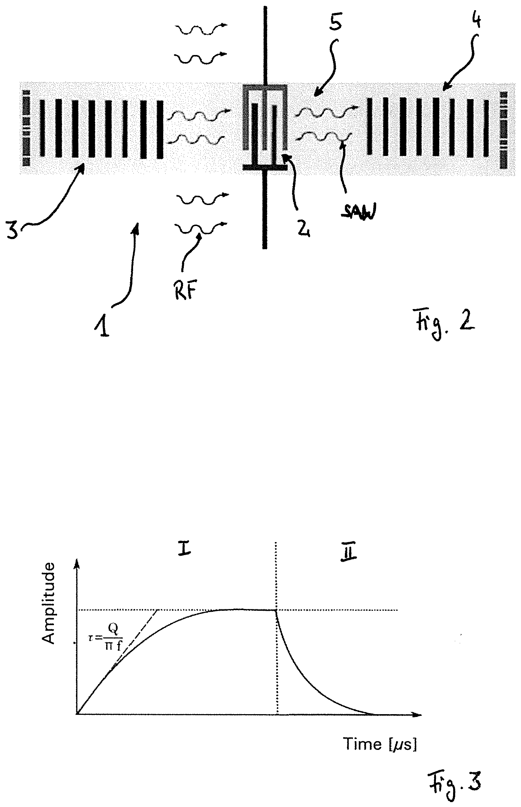

Fig.2 illustrates a typical one port SAW resonator according to the prior art (of the type as e.g. disclosed in Fig. 1 of William J. Tanski in "Surface Acoustic Wave Resonators on Quartz" (see above) or in KR 1020010056544 A) which is often used as a SAW sensor. The resonator 1 may in particular be arranged on a piezoelectric substrate, often chosen from a temperature stable cut of quartz, with polished surface which is suitable for low loss propagation of SAW (or Surface Transverse Waves, STW) on which a transducer 2 is situated between two reflectors 3, 4. The distance between the reflectors 3, 4, i.e. the width of a gap 5 between them, is adjusted in a known way to provide building up of the resonance mode coupled to the transducer 2, which is normally designed in form of a standard interdigital transducer (IDT) having two electrodes per wavelength. The design principles of such devices are well known and for example describe by William J. Tanski in "Surface Acoustic Wave Resonators on Quartz" (see above). The transducer 2 is often made up as a long transducer structure with aluminum (Al) electrodes and often is used with reflectors 3, 4 designed as synchronous continuation of the transducer 2 with electrodes of the same type and design, but short-circuited, serving as reflector elements. When such a resonator 1 is excited by some radio frequency (RF) signal source with RF at an excitation frequency $F_E$ essentially equal to the Eigenmode resonance Frequency $F_R$ of the resonator 1, the amplitude of oscillations in the resonator 1 increases, and when such excitation is stopped the amplitude decays when the resonator 1 is losing its energy. A graph of the amplitude versus the time for such known resonator 1 is shown in Fig.2. The characteristic time of these "charge" (shown in sector I in Fig. 2) and "discharge" (shown in sector II in Fig. 2) processes is basically determined by the loaded Q-factor of the resonator:

$$T = \frac{Q}{\pi \cdot F_R} \ .$$

In all sensor systems based on the SAW resonators this "exponential tail" is received by an interrogator unit ("the reader") and analyzed for extraction of the sensor information. For example, the precise measurement of any shifts of the resonance frequency allows measuring the temperature of the sensor and/or its deformation. In the last case two or more resonators often are used simultaneously to provide sufficient data for extraction of both measurands. Therefore obtaining maximal Q-factors of the resonator is an important issue for such sensors.

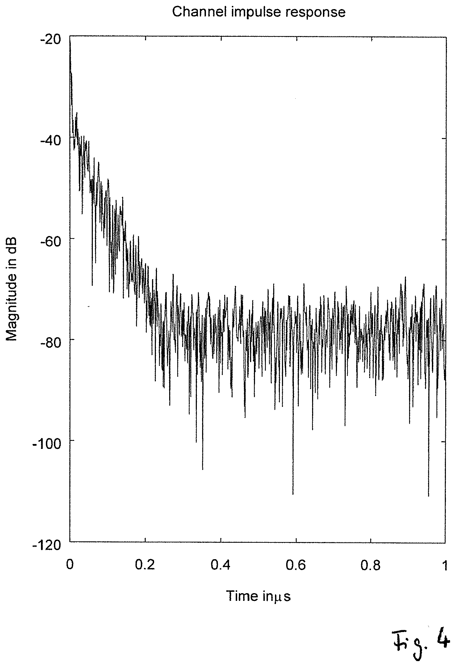

For frequently used 2.42 GHz ISM band expected Q-factors are of the order of 2000 to 3000 for the SAW (STW) resonators based on Al electrode structures. From above formula one sees that the decay time is about 1000 oscillation periods (Q/$\pi$) in this case, that is about 400 ns =0.4 $\mu$s. However, when used in industrial environment, or inside of metal constructions, the parasitic reflections continue about 0.3 $\mu$s to 1.0 $\mu$s (as shown in Fig. 4), and they will mask the response of the sensor. Because the Q-factor decreases with frequency f (Q*f $\approx$ 5 * $10^{12}$ for practical SAW resonators) one can estimate that the characteristic decay time of a resonator, that is measured as "exponential tail" becomes comparable with 1$\mu$s for frequencies f $\approx$ 1.4 GHz and higher.

So, immediate response of the resonator and the short duration of such response is one of the problems of the currently used technical solutions for SAW sensors, especially if 2.4 GHz ISM band is supposed to be used. Another problem is related to the presence of the metal electrodes inside the resonator cavity. Metal usually is a material which significantly poorer properties with regard to acoustic applications than mono-crystalline dielectrics, propagation losses in metal electrodes are much higher.

In SAW delay line types of SAW sensors the parasitic reflections from environment can be set aside by introducing the initial delay, typically in the order of 1 $\mu$s, so that the signals reflected by environmental objects in a distance < 150 m arrive during this interval and the signals arriving later are strongly attenuated. But SAW sensors based on such technology demand more complicated reader systems and can operate only in rather wide frequency bands.

Another problem is that the changing impedance of the load, while connecting the sensor to an antenna, influences the resonance frequency which finally may dramatically decrease accuracy of measurements provided by the sensor and may demand complicated calibration procedures.

The resonance frequency of the SAW resonators with Al electrodes is rather dependent on the thickness of the Al metal of the electrodes. Therefore technological variations of the metal thickness result in variations of the device resonance frequency and, finally, demand individual calibration of each sensor.

So, for the present invention, it is an object to address to the problems present in the state of the art as outlined above.

This object is met with the present invention.

According to the invention a surface acoustic wave sensor comprises:

- a substrate having a surface suitable for propagation of surface acoustic waves, SAW, in a first direction and
- a surface acoustic wave transducer having a passband and being arranged on said surface said surface acoustic wave transducer being responsive to an interrogation signal for generating SAW propagating in said first direction and within an acoustic channel having a width in a direction perpendicular to the first direction.

The specific and novel feature of the surface acoustic wave sensor according to the invention is that

- at least one Fabry-Perot-type resonator for SAW is arranged at a distance $D_0 = \dfrac{V_{SAW} \cdot T_{init}}{2}$ from said transducer providing for a selected initial delay $T_{init}$, with $V_{SAW}$ being the velocity of SAW propagation in said first direction on a free surface of said substrate, i.e. a surface not being "disturbed" by any barriers like gratings, metallization or the like.,

- wherein said Fabry-Perot-type resonator contains a first reflector facing the acoustic wave transducer, a second reflector and a resonator cavity between said first and second reflectors,
- wherein said Fabry-Perot-type resonator has an Eigenmode resonance frequency $F_R$ within the passband of said transducer, and
- wherein said Fabry-Perot-type resonator at least partly overlaps with said acoustic channel.

By arranging the Fabry-Perot-type resonator at a distance Do to the transducer there is achieved a delay time which is based on the time the SAW needs to propagate from the transducer to the resonator and back. This delay time may be set according to the specific demands by varying the distance $D_0$. This delay time allows the response to the interrogation signal to be delayed by the sensor until parasitic reflections and other disturbing signals also caused by the interrogation signal but not reflecting any parameters the sensor is designed to detect have decayed. Further, the resonating properties of the Fabry-Perot-type resonator guarantees a strong enough response signal to reliably analyse for the respective properties reflecting the detected values of the parameters the sensor surveys.

Rather in contrast to the prior arrangements where the transducer was placed inside the resonance cavity (gap) of the Fabry-Perot-type resonator, for the invention the transducer is placed outside said cavity. Beside the advantageous delay this also leads to "loosing" the influence of the transducer structure and properties to the (Eigenmode) resonance frequency of the resonator, which makes the latter easier to calibrate and also renders it more precise in its response as not being influenced by dynamic effects of the transducer, in particular during excitation.

For SAW most reflector elements are of low reflectivity. Hence, in order to enhance reflectivity of the reflectors of the Fabry-Perot-type resonator it may be desirable to create each of the first and second reflectors of the resonator by a respective distributed reflector grating consisting of periodically arranged reflector elements having their planes of reflection oriented perpendicular to the first direction and having a period

$$p_1 = \frac{\tilde{\lambda}}{2} = \frac{\tilde{V}_{SAW}}{2 \cdot F_R},$$

with $\tilde{\lambda}$ being the wavelength of the surface acoustic waves (SAW) and $\tilde{V}_{SAW}$ being the SAW velocity inside said grating. The period $p_1$ in this context is meant to be the distance between adjacent reflector elements of the grating, measured from centre to centre of the elements. With such reflectors being made up as distributed gratings of reflector elements reflectivity of each reflector can be enhanced significantly and thus a Fabry-Perot-type reflector with optimized resonance properties can be achieved.

For such a resonator with reflectors being made up as distributed gratings the resonator cavity may consist of a gap between the reflectors, said gap having a gap width, being the distance from the first to the second reflector, said gap width being equal to $p_1 + n \cdot \dfrac{\lambda}{2} \pm \dfrac{\lambda}{4}$,

$$\lambda = \frac{V_{SAW}}{F_R},$$

with $p_1$ being the period of the grating and n being a natural number or 0, preferably $n = 0$.

For a resonator with reflectors being made up as distributed gratings, according to the invention, the first reflector facing said surface acoustic wave transducer may further be made up of less reflector elements in the grating than the second reflector. This will allow providing reduced reflectivity of the first reflector for an optimized coupling of the resonator to the incident SAW generated by the transducer.

Rather instead being "empty", i.e. free from structures influencing the SAW, within the resonator there may be set a number of periodically arranged reflecting elements with different, preferably reduced, period compared to the period of the reflector elements making up the reflectors of the resonator. This will make the SAW propagation condition more uniform in the entire structure and thus reduce loss of SAW energy caused by scattering of SAW on a gap with free surface. Further, this may assist in tuning the resonator to a sharp and definite resonance frequency *FR*.

An acoustic wave sensor according to the invention in an advantageous embodiment may contain as transducer a unidirectional transducer, which in particular may be a single phase unidirectional transducer, SPUDT. Such unidirectional transducer which may be a unidirectional interdigital transducer (unidirectional IDT, UDT), which will of course be arranged to emit SAW into the direction of the Fabry-Perot-type resonator, will allow to avoid losses of excitation energy from such SAW propagating along the first direction but to the opposite side of the Fabry-Perot-type resonator. Further, the reception loss is reduced.

Simulation of such device shows that the signal reflected back to the transducer from the Fabry-Perot-type resonator includes two components: direct reflection from the first grating and the response of the resonator, which resonator accumulates the SAW energy and emits part of the energy through the first reflector grating which is transparent for SAW to a low fraction. It looks like these components interfere destructively, at least partly.

To cancel the direct reflection one may also arrange a third reflector, being of identical design as the first and second reflectors, on the side of the transducer being opposite to the Fabry-Perot-type resonator, and at the same distance as the first reflector surplus an addi-

tional offset of $\pm\dfrac{\lambda}{4}$, with $\lambda$ being the wavelength of the SAW on a free surface substrate.

In a surface acoustic wave sensor of the invention the first and second reflectors of said resonator and/or the third reflector may consist of reflector elements in the form of shallow grooves in said substrate. The reflector elements, however, may also be provided in the form of metal electrodes, e.g. Al-electrodes, which usually are short-circuited.

For the surface acoustic wave sensor of the invention the acoustic channel may be subdivided into at least two parallel sub-channels and at least one additional resonator is situated in one of the at least two parallel sub-channels with a different initial delay and/or operating at a different resonance frequency inside the frequency band of the transducer. So, responses from two resonators may be distinguished and information on specific parameter values determined with the sensor may be read with more reliability and/or variety.

In an alternative construction, not according to the invention, the resonator may comprise as first and second reflectors respective distributed reflector gratings with periodically arranged reflector elements having their reflective planes oriented in parallel to the first direction, the reflectors in the gratings each being arranged with a period $p_2 = \dfrac{\lambda_\perp}{2} = \dfrac{V_\perp}{2 \cdot F_R}$, where $V_\perp$ is the SAW velocity in a second direction of the surface being perpendicular to the first direction, the said reflector gratings being separated by a gap providing the operation of the said resonator at the Eigenmode resonance frequency $F_R$ and said gap including a coupling reflector oriented at an angle $\alpha$ to first direction, with

$$\alpha = \arctan\left(\frac{V_\perp}{\hat{V}_{SAW}}\right),$$

with $\hat{V}_{SAW}$ being the SAW velocity in OX direction and inside the respective gratings. In principle, the SAW velocity in OX direction is slightly different for 1. a free surface, 2. inside a grating with elements perpendicular to 0X and 3. inside a grating with elements parallel to OX. So, using here a modified symbol for velocity, namely $\tilde{V}_{SAW}$ is expressing the situation in a very correct manner. But in practice for grooved gratings these differences in velocities are negligible, so that one can also assume $\tilde{V}_{SAW} = V_{SAW}$.

In this arrangement described above, the surface transverse waves (STW) may be exploited to generate the signal carrying the required information. In some occasions using STW for resonance may be preferable to using the "regular" SAW.

For the surface acoustic wave sensor of the invention the substrate may in particular be a piezoelectric substrate. It is however possible to make use of substrates being at least in some areas made of other types of material, e.g. glass, with the transducer being arranged in an area covered with a piezoelectric film or featuring piezoelectric properties by other means or measures.

The surface of any kind of substrate in particular may be a polished one as such kind of surface finishing allows for very good propagation of SAW.

For most known applications it will be suitable to set the initial delay time $T_{init}$ to a value of about 1 $\mu$s.

The invention further provides a method of use of a surface acoustic wave sensor according to one or more aspects being described above in combination with an interrogator means comprising a transmitter for launching the interrogation pulse in combination with a receiver for receiving a response signal from the surface acoustic wave sensor,

- wherein an excitation pulse is provided with the interrogator means and at a frequency essentially close to $F_R$ and with a duration $T_{sent}$ essentially longer than $\dfrac{Q}{\pi \cdot F_R}$, with $Q$ being the loaded quality factor of the resonator,

- wherein the receiver is kept switched off during the duration $T_{sent}$ of the excitation pulse being sent by the interrogator means, and

- wherein the receiver is switched on after the end of the interrogation pulse duration $T_{sent}$ and with an additional delay comparable to the initial delay $T_{init}$ of the surface acoustic wave sensor,

- wherein the receiver after having been switched on receives the signal reflected by the resonator and sent back from the surface acoustic wave sensor, and

- wherein the parameters of the exponentially decaying reverberation response signal from the sensor received by the receiver are analyzed and sensor information, such as temperature, deformation and /or other physical or chemical influences on the sensor, is extracted from the said reverberation response signal.

Following this method the effect aimed at, namely delaying the response of the sensor until parasitic signals have decayed will be achieved. It is to be noted here, that the interrogator means may also contain the receiver by means of integration. In fact it may be desirable to integrate the receiver into the interrogator means as high sensitivity of the interrogator means is provided due to correct sequence of sent and received signals achieved by using the same local oscillator in the transmitter and receiver of the interrogator means. Both, transmitter and receiver, usually are controlled by microprocessor.

In a specific embodiment there may be interrogated a number of separate surface acoustic wave sensors according to one or more of the aspects described previously herein by the same interrogator means and the said sensors may then be individually identified and distinguished by different initial delays $D_0$ and/or by different frequencies of the resonance of their respective resonators. By this means in one single interrogation step more than one, even a plurality of sensors may be read out and the response signals analyzed for respective parameter values they encode.

BRIEF DESCRIPTION OF THE DRAWINGS

Further features and advantages of the invention may be seen from the following description of embodiments referring to the drawings attached. It is also the essence of the present invention that can be easily understood with the help of the following detailed description read in conjunction with the figures briefly enumerated here. As it is common, some features in the figures are not represented in scale, but emphasize the device parts essential for understanding of the invention. Some other features are presented symbolically. The same characters are used throughout the figures and description to denote like elements. In the drawings:

Fig. 1    shows a Fabry-Perrot-type resonator as disclosed in the prior art together with a frequency spectrum of transmission;

Fig.2     schematically shows a common type SAW resonator device according to the state of the art;

Fig.3     illustrates the process of "pumping energy" into a standard SAW resonator, that is its excitation by an interrogation signal, and its "discharge", when the oscillation dies out due to loss of energy in the regime of free oscillations, with part of this energy being re-radiated to the interrogator;

Fig.4     shows environmental echoes in the time domain when the interrogation signal is launched inside a metal box and returns to the interrogator antenna after multiple reflections by surrounding objects, with the echoes decaying to an acceptable low level after about 0.3 to 0.5 microseconds as shown;

Fig.5     schematically shows the main idea of this invention, being use of a Fabry-Perrot-type resonator placed aside the transducer which consequently is placed outside of the resonator, for providing significant delay time for propagation of SAW between the transducer and the resonator;

Fig.6     shows a first preferred embodiment of the device with illustration of the main details thereof;

Fig.7     in a graph shows the simulated response of the device when it is interrogated with pulses of different duration, with the additional delay shown serving to keep response level during the decay of environmental echoes;

Fig.8     in another graph shows details of the response to the case of rather long interrogation pulse of 0.5 µs and illustrates the difference made by an additional reflector placed on the side of the resonator structure being opposite to the transducer;

Fig.9     shows a second preferred embodiment of the sensor according to the invention with and additional reflector serving to cancel direct reflections from the first reflector of the resonator;

Fig. 10   shows a realization of the resonator with "distributed gap" as in a third preferred embodiment which can be used to make the SAW propagation condition more uniform in the entire structure and thus reduce loss of SAW energy caused by scattering of SAW on a gap with free surface;

Fig. 11   illustrates the main idea of a fourth preferred embodiment, wherein at least two Fabry-Perot-type resonators are situated in the acoustic channel of the transducer; and

Fig. 12   shows an alternative sensor, not according to the invention, with the Fabry-Perot-type resonator arranged rotated by 90°, which can exploit surface transverse waves (STW) providing high Q-factor while the delay is realized with Rayleightype of SAW.

DETAILED DESCRIPTION OF THE INVENTION

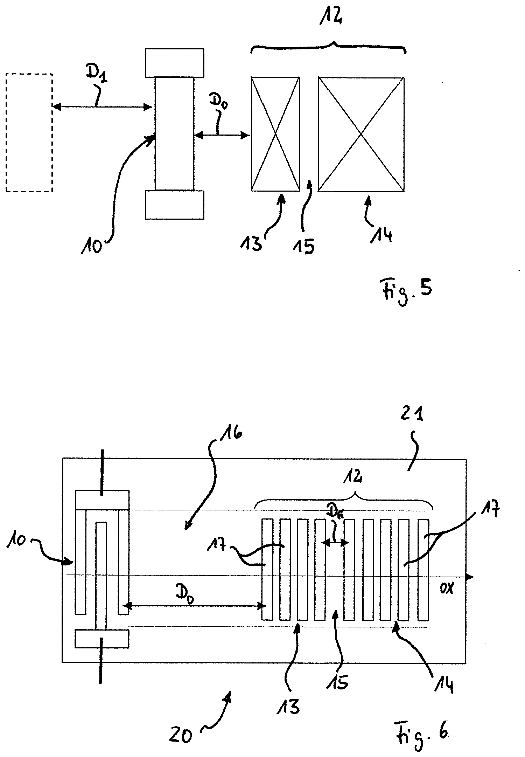

The general and main idea of invention is illustrated in Fig.5. A transducer 10, here in the form of an interdigital transducer, receiving an interrogation or excitation pulse transforms said pulse into pulse SAW which propagates to a Fabry-Perot-type resonator 12 created by reflectors 13 and 14 and by a cavity gap 15 between them. A duration $T_{pulse}$ of the excitation pulse must be sufficient for building up oscillations in the res-

$$T_{pulse} > \frac{Q}{\pi \cdot F_R},$$

onator,   with Q being the quality factor of the resonator 12 and $F_R$ the Eigenmode resonance frequency of the resonator 12.

An internal initial delay $T_{init}$ allows to delay the response from resonator 12 during this time $T_{init}$, and to wait until the environmental echoes have died after the excitation pulse has been switched off. (Normally the very sensitive receiver cannot work simultaneously with the excitation pulse being generated.) After that a reader receiver (not shown) receiving the response signal can analyze the "after sound" corresponding to the decaying free oscillations in the resonator 12 in order to get information as the value(s) of one or more certain parameter(s) detected by the sensor. This process will be described and considered in further detail further below.

The advantages of existing delay-line type of sensors are thus included in this invention without also adopting their disadvantages. Moreover, different initial delays can be used for identification of two or more sensors (not shown in the scheme according to Fig. 5).

In the following, some preferred embodiments of this invention will be described by way of examples. To those skilled in the art numerous variations, changes and substitutions may occur without departing from the invention.

1st Preferred Embodiment

The first preferred embodiment of the invention is illustrated in Fig. 6.

The sensor 20 of this embodiment includes piezoelectric substrate 21 with polished surface suitable for low loss propagation of SAW in a first direction, here named direction OX, and a surface acoustic wave transducer 10 being situated on said surface 21 and being responsive to an interrogation signal for generating propagating surface acoustic waves in said first direction OX. The transducer 10 in this embodiment is an interdigital transducer (IDT) and may in particular be a single phase unidirectional IDT (SPUDT). The sensor 20 further includes at least one Fabry-Perot-type resonator 12 for SAW which is situated in an acoustic channel 16 of said

$$D_0 = \frac{V_{SAW} \cdot T_{init}}{2},$$

transducer 10 at a distance $D_0$, with

with $V_{SAW}$ being the velocity of SAW propagation in the first direction OX on a free substrate surface, and said Fabry-Perot-type resonator 12 at least partly overlapping with said acoustic channel 16. In this arrangement the distance $D_0$ provides the chosen initial delay $T_{init}$ which may for example be comparable with 1 μs. The Fabry-Perot-type resonator 12 is created by two reflectors 13 and 14 separated by a gap 15. In this embodiment the reflectors 13 and 14 are construed of gratings of reflector elements 17, in particular in the form of distributed Bragg-type reflectors.

As substrate material for example quartz, lithium niobate, lithium tantalate or other substrates used for low loss SAW devices can also be used here. Layered structures such as AlN/sapphire, AlN on diamond, etc. can be also used. If nonpiezoelectric substrates are used for the resonator structures, piezoelectric properties need to be set up in the area of the transducer, e.g. by applying an appropriate coating.

The transducer 10 shown schematically in Fig. 6 as standard interdigital transducer (IDT), can - as already pointed out to - be also of unidirectional type, which will reduce the loss of device by about 6 dB, and shall preferably be designed as narrow band transducer adopted to the impedance of antenna, typically to 50 Ohm.

The reflectors 13, 14 can be made as metal (typically Al) electrodes (short-circuited by additional busbars not shown in Fig. 6 or open), but preferably are made in the form of shallow grooves in the substrate material.

The width $D_G$ of the gap 15 can be selected equal to

$$\left(k + \frac{1}{2}\right) \cdot p = \left(k + \frac{1}{2}\right) \cdot \frac{\lambda}{2},$$

with k = 1,2,...

and taken from center to center of the opposing reflector elements 17 adjacing the gap 15 on either side. The most preferred value for $k$ is $k = 1$ since it is preferred to keep the gap as narrow as possible.

The outer reflector 14 being distal to the transducer 10 and providing for back reflection to the transducer 10 must have a total reflection coefficient close to 1, that is, in order to provide high reflectivity, the number Nrefl of reflector elements 17 must be sufficiently high, i.e. it shall fulfill the following relation: z·|Nrefl|>>1, with r being the reflection coefficient of one reflector element 17 (whether groove or electrode). The reflectivity of the inner reflector 13 being proximal to the transducer 10 must be optimized to provide optimal coupling of the SAW generated by transducer 10 to the Fabry-Perot-type resonator 12. The finite transparency of the inner reflector 13 must be selected in a way that the Q-factor of the resonator 12 is reduced about two times compared to the limit of practically non-transparent reflectors. Higher transparency (for SAW) would result in too much loss of the Q-factor, while lower transparency will not allow reaching maximum amplitude of oscillations. In other words the optimized transparency of the inner reflector shall provide the highest possible accumulation of SAW energy in the resonator 12.

In this aspect, two advantageous features of grooved-type reflector elements 17 can be stressed. First, such resonator 12 with reflectors 13, 14 being construed with grooved-type reflector elements 17 has no metal inside the resonance cavity, thus providing higher Q-factor. Metal electrodes usually are responsible for principal part of loss in SAW resonators, because the acoustic loss in metals is incomparably higher than in mono-crystalline substrate material. This advantage is especially important if a high piezo-coupling substrate, such as $LiNbO_3$ or $LiTaO_3$ is used.

Second, the use of shallow grooves as reflector elements 17 allows control of reflectivity, in a way that very weak reflector elements 17 can be used allowing for small bulk-wave scattering effect and increasing Q-factor. Shallow grooves have negligible influence on SAW velocity, which makes the resonator 12 more reproducible and will allow hitting the desired operation frequency without tuning. Such sensor will need no calibration.

The frequency of the resonance is automatically situated in the center of stop-band of the reflector 12 (as e.g. done in the prior art according to Fig. 1) if the width $D_G$ of the cavity gap 15 equals to $\left(k+\dfrac{1}{2}\right)\cdot\dfrac{\lambda}{2}$, with k = 1,2,... , with small k preferred. Minimal possible gap is $\dfrac{3}{4}\cdot\lambda$ and will typically be preferred to use. The sensitivity to manufacturing errors of the width of grooves (or electrodes) as reflector elements is reduced in this case, since the resonance position is independent on their reflectivity. The case k = 0 is also possible, but in such case two reflector elements near such "gap" can overlap and will represent a large single grove or large electrode.

Another significant advantage of the invented sensor 20 is that connection of an antenna to the transducer 10 will practically not affect the resonance frequency $F_R$ of the resonator 12, because contrary to the standard SAW resonator, in the proposed sensor 20 the transducer 10 is situated outside the resonance cavity (the gap 15) and is not influencing the SAW propagation inside the resonator 12.

Device Operation:

In a way of example and in order to demonstrate the device operation principles, the structure presented in Fig. 5 has been modeled using COM model and precise FEMSAW software package belonging to GVR Trade SA. The substrate material was $128°\text{-LiNbO}_3$.

The transducers 10, 11, here IDTs, are the common and well known "two electrodes per $\lambda$" transducers with alternating electrode polarities. The total number of electrodes in IDT 10, shown in Fig. 5 on the left side, was set to twenty The aperture (being equal to the main overlapping part of the fingers of the IDT) of the structure was set to 100 $\mu$m. The first reflector 13 of the Fabry-Perot-type resonator 12 shown on the left side in the figure was set to contain fifteen electrodes as resonator elements. And there were set fifty resonator elements in the form of electrodes to be contained in the second reflector 14 of the resonator 12, shown on the right side in the figure. The distance between IDT 10 and the first reflector 13 was set to 1414.0 $\mu$m. The length of the resonator cavity 15, i.e. the distance between the two reflectors 13, 14 was set to include 25.5 pitches of the structure (one pitch including the width of one electrode and one gap and being equal to 0.81 $\mu$m in this structure). The chosen periods (one period here being meant to include the widths of two adjacent electrodes and two gaps) correspond to the device operation at about $F_R$ = 2445 MHz.

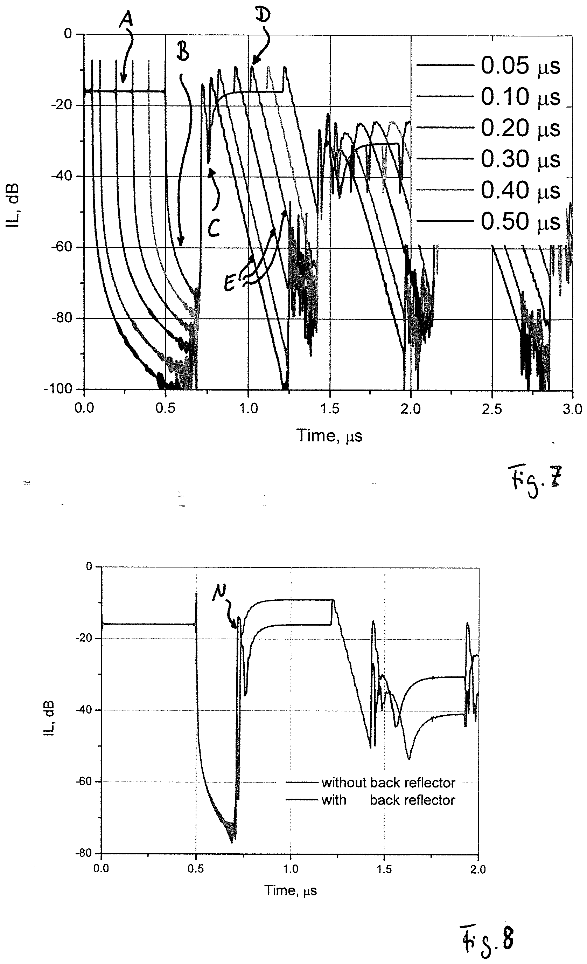

Fig. 7 shows the time responses of IDT 10 in time domain. The duration of a launching pulse is 50 ns - 500 ns, and its amplitude is 1 V. It is assumed that the frequency of the pulse is equal to the resonant frequency $F_R$ of the resonator 12.

When an interrogation pulse is applied to IDT 10 at initial moment t = 0, there is observed practically immediate response (area marked by A in Fig. 7) due to reflection from this IDT 10 as from capacitor. When the interrogation pulse ends, say at 0.5 $\mu$s, as shown in Fig. 8, this response also disappears. During some time (section B in Fig. 7) there is practically no response, since direct reflection does not exist anymore, and reflections from the Fabry-Perot-type resonator 12 have not arrived yet because of the initial delay $T_{init}$ caused by the SAW travelling the distance $D_0$. Then after the delay ($T_{init} \approx 0.7$ $\mu$s in our case) there is observed reflection from the first reflector 13 (section C in Fig. 7) which continues as long as continues the excitation pulse, maximum 0.5 s in Fig.8. Simultaneously, during this period, the reflection from the Fabry-Perot-type resonator 12 is built up during about 200 ns to 300 ns. This period is marked by D in Fig. 7. Finally, after end of delay time $T_{init}$ and the duration of the interrogation pulse, say 0.5 $\mu$s, the excitation pulse and the direct reflection from the first reflector come to an end and one observes exponentially decaying free oscillations in the resonator 12 (section E in Fig. 7) which, without being fed any more, loses accumulated energy. The end of interrogation pulse at t = 0.5 $\mu$s, i.e. the moment when the transmitter of the reader or interrogation device is switched off, and the beginning of measured resonator response are separated by introduced delay $T_{init}$ during which the receiver of the reader may be switched off and the environmental echoes decay to an acceptable, i.e. non-disturbing, level.

This is the main advantage of the sensor: Its fast decaying response is delayed and appears when there are no more strong environmental parasitic reflections.

The notch N in response appearing in Figs. 7 and 8 after beginning of the resonator response indicates that the resonator response and the direct reflection of the first reflector 13 are out of phase. When the SAW generated by the IDT 10 due to applied interrogation pulse ends to arrive to the Fabry-Perot-type resonator 12 there is observed a jump in the amplitude of the signal reflected by the resonator 12, because the destructive interference ends.

It should be clear from this example to the person skilled in the art that the designer must try to get the highest possible Q-factor for the resonator 12 that will make the after-sound longer. The transparency of the first reflector 13 must be optimized in a way to maximize the accumulation of SAW energy in the resonator 12 when excited by the incident interrogation pulse. The method of designing reflector gratings and SAW resonators are well developed and described, for example, by William J. Tanski in "Surface Acoustic Wave Resonance on Quartz" (see above).

2nd Preferred Embodiment

In a second preferred embodiment illustrated in Fig.9, a standard bi-directional IDT is used as transducer 10. In this embodiment, in order to cancel direct reflection from the first reflector 13 of the resonator 12 an additional reflector 23 which in this case is identically built as compared to the first reflector 13 is placed on the opposite side from IDT 10 at a distance

$$D_1 = D_0 \pm \frac{p}{2} = D_0 \pm \frac{\lambda}{4} \, .$$

The waves reflected by this additional reflector 23 arrive to IDT 10 with opposite phase compared to the waves directly reflected by the first reflector 13. Thus, only the waves reflected by Fabry-Perot-type resonator 12 are registered by IDT 10, as shows Fig. 8. Although it does not change the amplitude of the reflected signal, when the excitation is ended (that is in zone "E"), depending on the reader algorithm such stronger response during the excitation period can be useful.

### 3rd Preferred Embodiment

In this embodiment the gap between the reflectors 13 and 14 of the Fabry-Perot-type resonator 12 is replaced by a grating 25 of reflecting elements 27 with reduced period compared to the period of the reflector elements 17 in the reflectors 13 and 14. Fig. 10 shows a fragment of the sensor including such Fabry-Perot-type resonator 12, with reflectors 13 and 14 separated by a cavity with reflecting elements 27 arranged periodically at reduced period. The number of reflecting elements 27 and the period in this "distributed gap" is selected according to the condition that between the two reflectors 13, 14 of the resonator 12 an off-set of $\frac{p}{2}$ is to be accumulated, that is the length $D_G$ of the cavity including the reflecting elements 27 shall equal $\left(m \pm \frac{1}{2}\right) \cdot p_R$ if the position of the resonance in the center of stop-band is desirable. In practice one can take, e.g. five reflector elements of each reflector 13, 14 near the minimal possible gap of $\frac{3}{2} p_R$ and replace them by eleven elements with smaller pitch by this omitting the gap. This particular feature of a "distributed gap" is especially useful for resonators based on strong piezoelectric materials, where the presence of gaps in the resonator may cause additional losses.

### 4th Preferred Embodiment

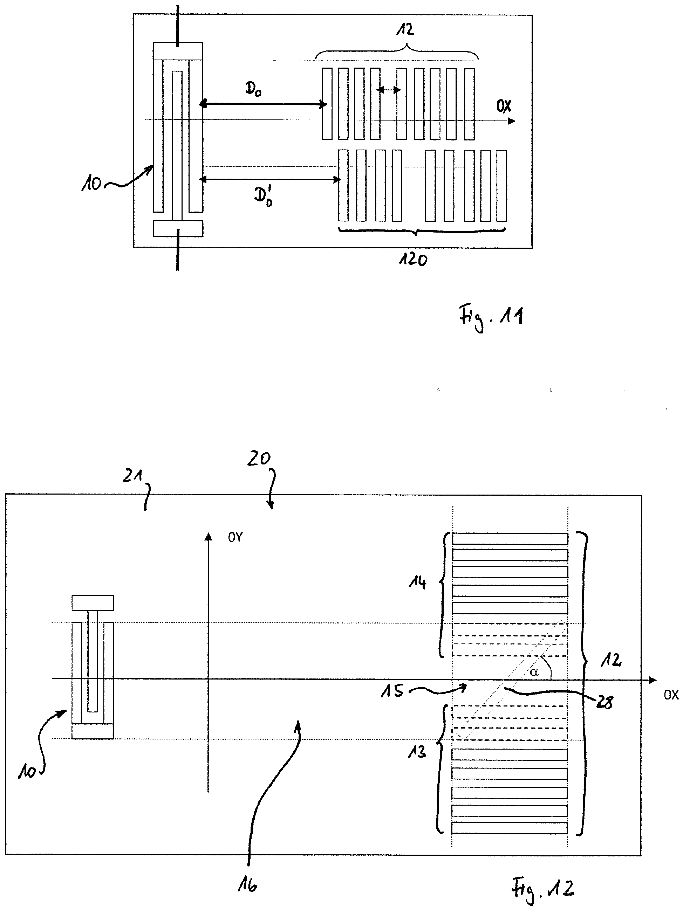

The fourth preferred embodiment is illustrated in Fig. 11 and includes two or more Fabry-Perot-type resonators 12, 120 situated in sub-channels of the acoustic channel of the transducer 10. For example, the initial delay $T_{init}$ of the resonators 12, 120 can be different by setting different distances $D_0$ between the IDT 10 and the resonators 12 and 120 respectively. If this difference in initial delay $T_{init}$ is larger than the duration of aftersound of the resonators 12, 120, the responses of the resonators 12, 120 can be registered independently not overlapping in time. The resonators 12, 120 can also or alternatively have different Eigenmode resonance frequencies $F_R$. Although not shown in Fig. 11, a design wherein a second Fabry-Perot-type resonator 120 is situated on the opposite side of the transducer 10 (either in the same acoustic channel or in a parallel sub-channel) is evidently also possible. Such device can be used, e.g., for simultaneous measurement of deformations and temperature if the resonators 12, 120 are placed or fixed in a way that their deformation is different.

### Alternative sensor (not according to the invention)

This sensor, shown in Fig. 12, includes the Fabry-Perot-type resonator 12 with reflectors 13, 14 made up of reflector elements 17 arranged with their reflective planes parallel to the propagation direction OX of the SAW generated by the IDT 10. On piezoelectric substrate 21, for example, a 36° rotated Y-cut of quartz, transducer 10 is situated suitably for efficient generation of SAW of Ray-leigh type which propagate in acoustic channel 16. The Fabry-Perot-type resonator 12 is thus created by reflectors 13, 14 with reflector elements 17 being oriented with their reflective planes parallel to the acoustic channel 16. The gratings of reflector elements 17 making up the reflectors 13, 14, in each one of the reflectors 13, 14 are periodically arranged with a period

$$p_2 = \frac{\lambda_\perp}{2} = \frac{V_\perp}{2 \cdot F_C} \, ,$$

where $V_\perp$ is the SAW (STW in this particular cut case) velocity in direction OY perpendicular to the propagation direction OX and $F_c$ is an operation frequency. To be precise, the velocity $V_\perp$ must be taken accounting for the influence of the electrode gratings 13, 14. However, this difference is negligible for shallow grooves. The two gratings making up the reflectors 13, 14 further are separated by a gap 15 providing operation of the Fabry-Perot-type resonator 12 at a frequency essentially close to $F_c$, wherein said gap 15 further includes a coupling reflector 28 oriented at angle $\alpha$ to the propagation direction OX, with

$$\alpha = \arctan\left(\frac{V_\perp}{V_{SAW}}\right)$$

The Fabry-Perot-type resonator 12 can exploit the Surface Transverse Waves (STW) while the transducer 10 generates SAWs close to Raleigh type. The STW resonators are known to have high Q-factors. The inclined coupling element 28 can be made in form of one or a few grooves or electrodes and can overlap with reflecting elements 17 as shown by dotted lines in Fig. 12. While for description of this invention exemplary embodiments have been used it should be clear to those having ordinary skills in the art that the variation in forms, details, materials can be made without departing from the scope of the present invention defined by the following Claims. For example, the "piezoelectric substrate" can actually be replaced by suitable layered structure, such as AlN/sapphire, etc.

5th Preferred Embodiment

This embodiment includes a Surface Acoustic Wave sensor of any of preceding embodiments in a combination with an interrogator means providing an excitation pulse to the transducer (by wired connection or remotely, e.g. by radio link) with frequency essentially close to $F_R$ and duration $T_{pulse}$ essentially longer than characteristic time of charge of the resonator $\dfrac{Q}{\pi \cdot F_R}$. In this embodiment a receiver which may be integral part of the interrogation device or designed separately may be, and preferably will be switched off during this period $T_{pulse}$ and switched on with a delay comparable with $T_{init}$ after end of the interrogation pulse. Then the interrogator receives exponentially decaying reverberation response signal from the sensor and analyzes its parameters in order to extract information on temperature, deformation and /or other physical or chemical influences on the sensor. Different combinations of delay $T_{init}$, duration of the interrogation pulse $T_{pulse}$, and decay time of the environmental echoes are possible. If the initial delay $T_{init}$ and the duration of the interrogation pulse $T_{pulse}$ are longer than the decay time of the environmental echoes, the receiver can be turned on after an end of said parasitic echoes (and after the end of the interrogation pulse) and will receive part of the pulse reflected by the resonator in the forced mode, when the incident wave still continues to arrive into the resonator.

A few sensors having different initial delay $T_{init}$ and/or different resonance frequencies $F_R$ can be identified and interrogated simultaneously by one reader. The difference between delays $T_{init}$ and also the grid of frequencies $F_R$ depends on the reader algorithms. If the maximum of reflected signal amplitude is detected the sensors cannot have overlapping in time responses, while it can be acceptable if the response frequency is analyzed by Fourier transform of received responses.

**List of Reference Numerals**

| | |
|---|---|
| 1 | resonator |
| 2 | transducer |
| 3 | reflector |
| 4 | reflector |
| 5 | gap |
| 10 | transducer |
| 12 | Fabry-Perot-type resonator |
| 13 | reflector |
| 14 | reflector |
| 15 | cavity (gap) |
| 16 | acoustic channel |
| 17 | reflector element |
| 20 | sensor |
| 21 | substrate |
| 23 | reflector |
| 25 | grating |
| 27 | reflecting element |
| 28 | coupling reflector |
| $\alpha$ | angle |
| A | section |
| B | section |
| C | section |
| D | section |
| $D_0$ | distance |
| $D_0{}'$ | distance |
| $D_1$ | distance |
| $D_G$ | width of reflector cavity |
| E | section |
| I | charging phase |
| II | discharging phase |
| N | notch |
| RF | interrogating radio frequency signal |
| SAW | surface acoustic waves |
| OX | direction |
| OY | direction |

**Claims**

1. A surface acoustic wave sensor comprising:

- a substrate (21) having a surface suitable for propagation of surface acoustic waves (SAW) in a first direction (OX) and
- a surface acoustic wave transducer (10) having a pass-band and being arranged on said surface, said surface acoustic wave transducer (10) being responsive to an interrogation signal (RF) for generating surface acoustic waves (SAW) propagating in said first direction (OX) and within an acoustic channel (16) having a width in a direction perpendicular to the first direction (OX) on a free surface of said surface, i.e. a surface not being "disturbed" by any barriers like gratings, metallization or the like, wherein

- at least one Fabry-Perot-type resonator (12) for surface acoustic waves (SAW) is arranged

$$D_0 = \frac{V_{SAW} \cdot T_{init}}{2}$$

at a distance from said transducer (10) providing for a selected initial delay $T_{init}$, with $V_{SAW}$ being the velocity of surface acoustic waves (SAW) propagation in said first direction (OX),
- wherein said Fabry-Perot-type resonator (12) contains a first reflector (13) facing the acoustic wave transducer (10), a second reflector (14) and a resonator cavity (15, 25) between said first (13) and second (14) reflectors,
- wherein said Fabry-Perot-type resonator (12) has an Eigenmode resonance frequency $F_R$ within the pass-band of said transducer (10), and
- wherein said Fabry-Perot-type resonator (12) at least partly overlaps with said acoustic channel (16).

2. A surface acoustic wave sensor according to claim 1, wherein the first (13) and second (14) reflectors of the said resonator (12) are each created by a respective distributed reflector grating consisting of periodically arranged reflector elements (17) having their planes of reflection oriented perpendicular to the first direction (OX) and having a period

$$p_1 = \frac{\tilde{\lambda}}{2} = \frac{\tilde{V}_{SAW}}{2 \cdot F_R} ,$$

with $\tilde{\lambda}$ being the wavelength of the surface acoustic waves (SAW) and $\tilde{V}_{SAW}$ being the SAW velocity inside said grating.

3. A surface acoustic wave sensor according to claim 2, wherein the resonator cavity (15) consists of a gap between the reflectors (13, 14), said gap having a gap width ($D_G$), being the distance from the first (13) to the second (14) reflector, said gap width ($D_G$) being equal to

$$p_1 + n \cdot \frac{\lambda}{2} \pm \frac{\lambda}{4} , \quad \lambda = \frac{V_{SAW}}{F_R}$$

, with n being a natural number or 0, preferably n = 0.

4. A surface acoustic wave sensor according to any of claims 2 or 3, wherein said first reflector (13) facing said surface acoustic wave (SAW) transducer (10) is made up of less reflector elements (17) in the grating than the second reflector (14), for providing reduced reflectivity for an optimized coupling of the resonator (12) to the incident surface acoustic waves (SAW) generated by the transducer.

5. A surface acoustic wave sensor according to any of claims 2 to 4, wherein within the resonator cavity (25) there is arranged a number of periodically sited reflecting elements (27) with different, preferably reduced, period compared to the period of the reflector elements (17) making up the reflectors (13, 14).

6. A surface acoustic wave sensor according to any of the preceding claims, wherein said transducer (10) is a unidirectional transducer, in particular a single phase unidirectional transducer, SPUDT.

7. A surface acoustic wave sensor according to any of claims 1 to 5, wherein a third reflector (23) is arranged on the side of the said transducer (10) opposite to the said resonator (12), and at the same distance ($D_0$) as the first reflector (13) surplus an additional offset of $\pm \frac{\lambda}{4}$, with $\lambda$ being the wavelength of the surface acoustic waves (SAW) on a free surface.

8. A surface acoustic wave sensor according to any of the preceding claims, wherein the first (13) and second (14) reflectors of said resonator (12) consist of reflector elements (17) in the form of shallow grooves in said substrate.

9. A surface acoustic wave sensor according to any of the preceding claims, wherein said acoustic channel (16) is subdivided into at least two parallel sub-channels and at least one additional resonator (120) is situated in one of the at least two parallel sub-channels with a different initial delay and/or operating at a different resonance frequency inside the frequency band of the transducer (10).

10. A surface acoustic wave sensor according to any of the preceding claims, wherein the substrate (21) is a piezoelectric substrate.

11. A surface acoustic wave sensor according to any of the preceding claims, wherein the said surface is a polished surface.

12. A surface acoustic wave sensor according to any of the preceding claims, wherein the initial delay $T_{init}$ is chosen to be in the regime of 1 $\mu$s.

13. A method of use of a surface acoustic wave sensor according to any of the preceding claims in combination with an interrogator means used for sending remotely an interrogation signal and for receiving a response signal from the surface acoustic wave sensor with a receiver contained in said interrogator means,

    - wherein an excitation pulse is provided with the interrogator means and at a frequency essentially close to $F_R$ and with a duration $T_{sent}$

$$\frac{Q}{\pi \cdot F_R},$$

essentially longer than ⎯⎯⎯⎯⎯⎯ with Q being the loaded quality factor of the resonator,
- wherein the receiver is kept switched off during the duration $T_{sent}$ of the excitation pulse being sent by the interrogator means, and
- wherein the receiver is switched on after the end of the interrogation pulse duration $T_{sent}$ and with an additional delay comparable to the initial delay $T_{init}$ of the surface acoustic wave sensor,
- wherein the receiver after having been switched on receives the signal reflected by the resonator and sent back from the surface acoustic wave sensor, and
- wherein the parameters of the exponentially decaying reverberation response signal from the sensor received by the receiver are analyzed and sensor information, such as temperature, deformation and /or other physical or chemical influences on the sensor, is extracted from the said reverberation response signal.

14. A method according to claim 13, wherein a number of separate surface acoustic wave sensors according to any of claims 1 to 12 is interrogated by the same interrogator means and the said sensors are individually identified and distinguished by different initial delays $D_0$ and/or by different frequencies of the resonance of their respective resonators.


**Patentansprüche**

1. Sensor für akustische Oberflächenwellen, umfassend:

- ein Substrat (21) mit einer Oberfläche, geeignet zur Ausbreitung von akustischen Oberflächenwellen (Surface Acoustic Waves, SAW) in einer ersten Richtung (0X), und
- einen Wandler (10) für akustische Oberflächenwellen, der ein Durchlassband hat und auf der Oberfläche angeordnet ist, wobei der Wandler (10) für akustische Oberflächenwellen auf ein Abfragesignal (RF) zum Generieren akustischer Oberflächenwellen (SAW) reagiert, sich ausbreitend in der ersten Richtung (0X) und innerhalb eines akustischen Kanals (16) mit einer Breite in einer Richtung senkrecht zu der ersten Richtung (0X) auf einer freien Oberfläche der betreffenden Oberfläche, d. h., auf einer Oberfläche, die nicht "gestört" von Hindernissen wie Gittern, Metallisierung oder Ähnlichem ist, wobei
- mindestens ein Fabry-Pérot-Resonator (12) für akustische Oberflächenwellen (SAW) in einem Abstand $D_0 = \frac{V_{SAW} \cdot T_{init}}{2}$ zum Wandler (10) angeordnet ist, wodurch eine ausgewählte erste Verzögerung $T_{init}$ bereitgestellt wird, wobei $V_{SAW}$ die Geschwindigkeit der Ausbreitung der akustischen Oberflächenwellen (SAW) in der ersten Richtung (0X) ist,
- wobei der Fabry-Pérot-Resonator (12) einen ersten Reflektor (13) beinhaltet, der dem Wandler (10) für akustische Oberflächenwellen gegenüberliegt, einen zweiten Reflektor (14) und ein Resonatorhohlraum (15, 25) zwischen dem ersten (13) und zweiten (14) Reflektor,
- wobei der Fabry-Pérot-Resonator (12) eine Eigenmode-Resonanzfrequenz $F_R$ innerhalb des Durchlassbands des Wandlers (10) hat, und
- wobei der Fabry-Pérot-Resonator (12) den akustischen Kanal (16) mindestens teilweise überlappt.

2. Sensor für akustische Oberflächenwellen nach Anspruch 1, wobei der erste (13) und zweite (14) Reflektor des Resonators (12) jeweils durch ein entsprechendes verteiltes Reflektorgitter gebildet werden, die aus periodisch angeordneten Reflektorelementen (17) bestehen, deren Ebenen der Reflexion senkrecht zur ersten Richtung (0X) ausgerichtet sind und die eine Periode $p_1 = \frac{\tilde{\lambda}}{2} = \frac{\tilde{V}_{SAW}}{2 \cdot F_R}$ haben, wobei $\tilde{\lambda}$ die Wellenlänge der akustischen Oberflächenwellen (SAW) und $\tilde{V}_{SAW}$ die SAW-Geschwindigkeit innerhalb des Gitters ist.

3. Sensor für akustische Oberflächenwellen nach Anspruch 2, wobei der Resonatorhohlraum (15) eine Lücke zwischen den Reflektoren (13, 14) umfasst, wobei die Lücke eine Lückenbreite ($D_G$) hat, die der Abstand zwischen dem ersten (13) und dem zweiten (14) Reflektor ist, wobei die Lückenbreite ($D_G$) gleich

$p_1 + n \cdot \frac{\lambda}{2} \pm \frac{\lambda}{4}, \lambda = \frac{V_{SAW}}{F_R}$ ist, wobei n eine natürliche Zahl oder 0 ist, vorzugsweise ist n = 0.

4. Sensor für akustische Oberflächenwellen nach einem der Ansprüche 2 oder 3, wobei der erste Reflektor (13), der dem Wandler (10) für akustische Oberflächenwellen (SAW) gegenüberliegt, in dem Gitter aus weniger Reflektorelementen (17) als der zweite Reflektor (14) besteht, sodass eine reduzierte Reflektivität für eine optimierte Kopplung des Resonators (12) an die vom Wandler generierten einfallenden akustischen Oberflächenwellen (SAW) bereitgestellt wird.

5. Sensor für akustische Oberflächenwellen nach einem der Ansprüche 2 bis 4, wobei innerhalb des Resonatorhohlraums (25) eine Anzahl periodisch angeordneter, reflektierender Elemente (27) mit einer im Vergleich zur Periode der Reflektorelemente (17), die die Reflektoren (13, 14) bilden, abweichenden, vorzugsweise reduzierten Periode angeordnet ist.

6. Sensor für akustische Oberflächenwellen nach einem der vorstehenden Ansprüche, wobei der Wandler (10) ein unidirektionaler Wandler ist, insbesondere ein unidirektionaler Einphasenwandler (Single Phase Unidirectional Transducer, SPUDT).

7. Sensor für akustische Oberflächenwellen nach einem der Ansprüche 1 bis 5, wobei ein dritter Reflektor (23) auf der Seite des Wandlers (10) gegenüber dem Resonator (12) angeordnet ist, und zwar in dem gleichen Abstand ($D_0$) wie der erste Reflektor, zuzüglich eines zusätzlichen Versatzes von $\pm \frac{\lambda}{4}$, wobei $\lambda$ die Wellenlänge der akustischen Oberflächenwellen (SAW) auf einer freien Oberfläche ist.

8. Sensor für akustische Oberflächenwellen nach einem der vorstehenden Ansprüche, wobei der erste (13) und der zweite (14) Reflektor des Resonators (12) aus Reflektorelementen (17) in der Form flacher Rillen in dem Substrat bestehen.

9. Sensor für akustische Oberflächenwellen nach einem der vorstehenden Ansprüche, wobei der akustische Kanal (16) in mindestens zwei parallele Unterkanäle unterteilt ist und sich mindestens ein zusätzlicher Resonator (120) in einem der mindestens zwei parallelen Unterkanäle mit einer anderen Anfangsverzögerung und/oder operierend mit einer anderen Resonanzfrequenz innerhalb des Frequenzbands des Wandlers (10) befindet.

10. Sensor für akustische Oberflächenwellen nach einem der vorstehenden Ansprüche, wobei das Substrat (21) ein piezoelektrisches Substrat ist.

11. Sensor für akustische Oberflächenwellen nach einem der vorstehenden Ansprüche, wobei die Oberfläche eine polierte Oberfläche ist.

12. Sensor für akustische Oberflächenwellen nach einem der vorstehenden Ansprüche, wobei die Anfangsverzögerung $T_{init}$ so gewählt wird, dass sie innerhalb des Regimes von 1 μs liegt.

13. Verfahren zur Verwendung eines Sensors für akustische Oberflächenwellen nach einem der vorstehenden Ansprüche in Kombination mit einem Abfragemittel, verwendet, um entfernt ein Abfragesignal zu senden und ein Reaktionssignal von dem Sensor für akustische Oberflächenwellen zu erhalten, wobei in dem Abfragemittel ein Empfänger enthalten ist,

  - wobei mit dem Abfragemittel ein Erregungsimpuls bereitgestellt wird, und zwar in einer Frequenz, die im Wesentlichen dicht bei $F_R$ liegt, und mit einer Dauer $T_{sent}$, die wesentlich länger als $\frac{Q}{\pi \cdot F_R}$ ist, wobei Q die belastete Güte des Resonators ist,
  - wobei der Empfänger während der Dauer $T_{sent}$, in welcher der Erregungsimpuls von dem Abfragemittel gesendet wird, ausgeschaltet bleibt, und
  - wobei der Empfänger nach dem Ende der Abfrageimpulsdauer $T_{sent}$ und mit einer zusätzlichen Verzögerung, die mit der Anfangsverzögerung $T_{init}$ des Sensors für akustische Oberflächenwellen vergleichbar ist, eingeschaltet wird,
  - wobei der Empfänger nach dem Einschalten das vom Resonator reflektierte und vom Sensor für akustische Oberflächenwellen zurückgesendete Signal empfängt; und
  - wobei die Parameter des sich exponentiell ausschwingenden Nachhallreaktionssignals von dem Sensor, empfangen von dem Empfänger, analysiert werden, und Sensorinformationen wie Temperatur, Deformation und/oder andere physikalische oder chemische Einflüsse auf den Sensor aus dem Nachhallreaktionssignal extrahiert werden.

14. Verfahren nach Anspruch 13, wobei eine Anzahl separater Sensoren für akustische Oberflächenwellen entsprechend einem der Ansprüche 1 bis 12 von denselben Abfragemitteln abgefragt werden und die Sensoren durch unterschiedliche Anfangsverzögerungen $D_0$ und/oder durch unterschiedliche Frequenzen der Resonanz ihrer jeweiligen Resonatoren einzeln identifiziert und unterschieden werden.

## Revendications

1. Capteur d'ondes acoustiques de surface comprenant:

  - un substrat (21) présentant une surface convenant à la propagation d'ondes acoustiques de surface (SAW) dans une première direction (OX) et
  - un transducteur d'ondes acoustiques de surface (10) présentant une bande passante et agencé sur ladite surface, ledit transducteur d'ondes acoustiques de surface (10) réagissant à un signal d'interrogation (RF) afin de générer des ondes acoustiques de surface (SAW) se propageant dans ladite première direction (OX) et possédant un canal acoustique (16) d'une certaine largeur dans une direction perpendiculaire à la première direction (OX) sur une surface libre de ladite surface, c'est -à- dire une surface non perturbée par des barrières telles que des grilles, une métallisation ou similaire,
dans lequel
- au moins un résonateur de type Fabry-Pérot (12) pour ondes acoustiques de surface (SAW) est disposé à une distance $D_0 = \dfrac{V_{SAW} \cdot T_{init}}{2}$ dudit transducteur (10)

- fournissant une temporisation initiale sélectionnée $T_{init}$, avec $V_{SAW}$ la vitesse de propagation des ondes acoustiques de surface (SAW) dans ladite première direction (OX), dans lequel ledit résonateur de type Fabry-Perot (12) comprend un premier réflecteur (13) faisant face au transducteur d'ondes acoustiques, un deuxième réflecteur (14) et une cavité de résonateur (15, 25) entre ledit premier réflecteur (13) et ledit deuxième réflecteur (14),
- dans lequel ledit résonateur de type Fabry-Pérot (12) possède une fréquence de résonance de mode propre $F_R$ sur la bande passante dudit transducteur (10), et
- dans lequel ledit résonateur de type Fabry-Pérot (12) se chevauche au moins partiellement avec ledit canal acoustique (16).

**2.** Capteur d'ondes acoustiques de surface selon la revendication 1, dans lequel le premier réflecteur (13) et le deuxième réflecteur (14) sont chacun créés par un réseau réflecteur distribué respectif consistant en des éléments réflecteurs (17) disposés de manière périodique et dont le plan de réflexion est orienté perpendiculairement à la première direction (OX) et

$$p_1 = \frac{\tilde{\lambda}}{2} = \frac{\tilde{V}_{SAW}}{2 \cdot F_R}$$

présentant une période ' avec $\tilde{\lambda}$ la longueur d'onde des ondes acoustiques de surface (SAW) et $V_{SAW}$ la vitesse des SAW à l'intérieur dudit réseau.

**3.** Capteur d'ondes acoustiques de surface selon la revendication 2, dans lequel la cavité de résonateur (15) est constituée d'un espace entre les réflecteurs (13, 14), ledit espace ayant une largeur d'espace (DG), correspondant à la distance séparant le premier réflecteur (13) et le deuxième réflecteur (14), ladite largeur d'espace (Dg) étant égale à

$$p_1 + n \cdot \frac{\lambda}{2} \pm \frac{\lambda}{4}, \; \lambda = \frac{V_{SAW}}{F_R}$$

' n étant un nombre naturel ou égal à 0, de préférence n = 0.

**4.** Détecteur d'ondes acoustiques de surface selon l'une quelconque des revendications 2 ou 3, dans lequel ledit premier réflecteur (13) faisant face audit transducteur d'ondes acoustiques de surface (SAW) (10) est constitué d'un nombre réduit d'éléments réflecteurs (17) dans le réseau de diffraction par rapport au deuxième réflecteur (14), pour fournir une réflectivité réduite et optimiser le couplage du résonateur (12) avec les ondes acoustiques de surface incidentes (SAW) générées par le transducteur.

**5.** Capteur d'ondes acoustiques de surface selon l'une quelconque des revendications 2 à 4, dans lequel à l'intérieur de la cavité du résonateur (25), on trouve un certain nombre d'éléments réflecteurs (27) disposés de manière périodique, laquelle période est différente, de préférence réduite, par rapport à la période des éléments réflecteurs (17) constituant les réflecteurs (13, 14).

**6.** Capteur d'ondes acoustiques de surface selon l'une quelconque des revendications précédentes, dans lequel ledit transducteur (10) est un transducteur unidirectionnel, en particulier un transducteur unidirectionnel monophasé, SPUDT.

**7.** Capteur d'ondes acoustiques de surface selon l'une quelconque des revendications 1 à 5, dans lequel un troisième réflecteur (23) est disposé sur le côté dudit transducteur (10) opposé audit résonateur (12), et à la même distance (Do) que le premier réflecteur (13) avec un décalage supplémentaire de +/- λ/4, λ étant la longueur d'onde des ondes acoustiques de surface (SAW) sur une surface libre.

**8.** Capteur d'ondes acoustiques de surface selon l'une quelconque des revendications précédentes, dans lequel le premier réflecteur (13) et le deuxième réflecteur (14) dudit résonateur (12) se composent d'éléments réflecteurs (17) sous forme de gorges peu profondes dans ledit substrat.

**9.** Capteur d'ondes acoustiques de surface selon l'une quelconque des revendications précédentes, dans lequel ledit canal acoustique (16) est subdivisé en au moins deux sous-canaux parallèles et au moins un résonateur supplémentaire (120) est situé dans un desdits au moins deux sous-canaux parallèles avec une temporisation initiale différente et/ou fonctionnant à une fréquence de résonance différente dans les limites de la bande de fréquence du transducteur (10).

**10.** Capteur d'ondes acoustiques de surface selon l'une quelconque des revendications précédentes, dans lequel le substrat (21) est un substrat piézoélectrique.

**11.** Capteur d'ondes acoustiques de surface selon l'une quelconque des revendications précédentes, dans lequel ladite surface est une surface polie.

**12.** Capteur d'ondes acoustiques de surface selon l'une quelconque des revendications précédentes, dans lequel la temporisation initiale $T_{init}$ est choisie dans le régime de 1 μs.

**13.** Procédé d'utilisation d'un capteur d'ondes acoustiques de surface selon l'une quelconque des revendications précédentes en combinaison avec un moyen d'interrogation utilisé pour envoyer à distance un signal d'interrogation et pour recevoir un signal de réponse en provenance du capteur d'ondes acoustiques de surface, avec un récepteur contenu dans ledit moyen d'interrogation

- dans lequel une impulsion d'excitation est fournie avec le moyen d'interrogation et à une fréquence essentiellement proche de $F_R$ et d'une durée $Tsent$ sensiblement plus longue que $\dfrac{Q}{\pi \cdot F_R}$, Q étant le facteur de qualité chargé pour le résonateur,
- dans lequel le récepteur est maintenu éteint pendant la durée $Tsent$ de l'impulsion d'excitation, pendant que celle-ci est envoyée par les moyen d'interrogation, et
- où le récepteur est allumé au terme de la durée d'impulsion d'interrogation $Tsent$ et avec une temporisation supplémentaire comparable à la temporisation initiale $Tinit$ du capteur d'ondes acoustiques de surface,
- dans lequel le récepteur, après avoir été allumé, reçoit le signal réfléchi par le résonateur et renvoyé par le capteur d'ondes acoustiques de surface, et
- dans lequel les paramètres du signal de réponse de réverbération décroissante de manière exponentielle, provenant du capteur et reçu par le récepteur, sont analysés et des informations provenant de capteur telles que la température, la déformation et/ou d'autres influences physiques ou chimiques agissant sur le capteur sont extraites dudit signal de réponse de réverbération.

**14.** Procédé selon la revendication 13, dans lequel un certain nombre de capteurs d'ondes acoustiques de surface séparés selon l'une quelconque des revendications 1 à 12 est interrogé par le même moyens d'interrogation et lesdits capteurs sont individuellement identifiés et distingués par différentes temporisations initiales $D_0$ et/ou par différentes fréquences de la résonance de leurs résonateurs respectifs.

Fig. 1

EP 2 871 474 B1

Fig. 2

$$\tau = \frac{Q}{\pi f}$$

Fig. 3

Channel impulse response

Fig. 4

Fig. 5

Fig. 6

Fig. 7

Fig. 8

Fig. 9

Fig. 10

Fig. 11

Fig. 12

**EP 2 871 474 B1**

**REFERENCES CITED IN THE DESCRIPTION**

**Patent documents cited in the description**

- KR 1020010056544 A

**Non-patent literature cited in the description**

- **WILLIAM J. TANSKI.** Surface Acoustic Wave Resonators on Quartz. *IEEE Transactions on Sonics and Ultrasonics,* March 1979, vol. SU-26 (2

- **WILLIAM J. TANSKI.** *Surface Acoustic Wave Resonators on Quartz*
- **WILLIAM J. TANSKI.** *Surface Acoustic Wave Resonance on Quartz*